# EUROPEAN PATENT APPLICATION

(11) **EP 2 461 387 A1**
(43) Date of publication of application: **06.06.2012**
(21) Application number: 10804372.0
(22) Date of filing: 26.07.2010
(51) Int. Cl.: H01L 51/50, H05B 33/10

(54) **VAPOR DEPOSITION MATERIAL FOR ORGANIC DEVICE AND METHOD FOR MANUFACTURING ORGANIC DEVICE**

(30) Priority: 31.07.2009 JP 2009179957; 24.09.2009 JP 2009219311
(71) Applicant: FUJIFILM Corporation, Tokyo 106-8620 (JP)
(72) Inventor: HAYASHI, Masayuki, Ashigarakami-gun Kanagawa 258-8577 (JP)
(74) Representative: Höhfeld, Jochen
(86) International application number: PCT/JP2010/062538
(87) International publication number: WO 2011/013626

(57) **Abstract**

A deposition material which is used for producing an organic device, wherein the deposition material has an average particle diameter of 10 µm to 200 µm where the average particle diameter is expressed by D50% and has a uniformity degree of 1.0 to 4.0 where the uniformity degree is expressed by D60% diameter/DI0% diameter.

## Description

### Technical Field

The present invention relates to a deposition material for organic devices such as an organic electroluminescent element, an organic thin film solar cell, an organic field-effect transistor, and a method for producing an organic device using the deposition material.

### Background Art

There has been studied a variety of organic devices with use of an organic compound, including an organic electroluminescent element, for the purpose of achieving their practical use. The organic devices are generally composed of a thin film formed by depositing an organic deposition material containing the organic compound, so that performance of the resulting organic devices may be affected by a deposition rate of the deposition material employed.

Thus, the deposition material for organic devices has been studied in some conventional technologies.

For example, it has been suggested that some pelleted organic deposition materials having gas content of 1 mol % or less are deposited to form an organic layer (see PTL 1).

However, there are some problems for the pelleted organic deposition materials suggested above that they are too large in size and difficult to undergo thermal treatment during deposition since the pelleted organic deposition materials have been prepared by solidifying particulate organic deposition materials into a given shape.

There has also been suggested a method for preparing the pelleted organic deposition materials by mixing together organic sublimable powder and thermal-conductive non-sublimable powder (see PTL 2).

Even using the suggested method in which the pelleted organic deposition materials contain the thermal-conductive non-sublimable powder, however, it is impossible to successfully overcome the above problems, i.e., difficulty to undergo thermal treatment during deposition, and thereby, another problem in difficulty to deposit them in a steady deposition rate may be further caused. Variation in deposition rate can lead to variation in performance of the organic devices, while causing great variation in film thickness during forming the organic layer having a large area, and therefore, it may lead to an additional problem of a drop in yield.

### Citation List

### Patent Literature

PTL 1: Japanese Patent Application Laid-Open (JP-A) No. 11-92915
PTL 2: JP-A No. 2003-115381

### Summary of Invention

### Technical Problem

The present invention aims to solve the above existing problems and achieve the following objects. Specifically, an object of the present invention is to provide: a deposition material having excellent stability of the deposition rate and an ability to uniformly form a large-area film containing an organic compound, while reducing variation in performance of the resulting organic devices; and a method for producing an organic device using the deposition material.

### Solution to Problem

Means for solving the above problems are as follows.
<1> A deposition material which is used for producing an organic device, wherein the deposition material has an average particle diameter of 10 µm to 200 µm where the average particle diameter is expressed by D50%, and has a uniformity degree of 1.0 to 4.0 where the uniformity degree is expressed by D60% diameter/D10% diameter.
<2> The deposition material according to <1>, wherein the deposition material contains an organic compound or an inorganic oxide.
<3> The deposition material according to <1> or <2>, wherein the deposition material is used for forming at least one organic layer disposed between a pair of electrodes of an organic electroluminescent element.
<4> The deposition material according to <3>, wherein the organic layer is a luminescent layer.
<5> The deposition material according to <4>, further including an Ir complex or a Pt complex.
<6> A method for producing an organic device, including:
   depositing the deposition material according to any one of <1> to <5> by a flash deposition method to form an organic layer.
<7> An organic device obtained by the method for producing an organic device according to <6>.

### Advantageous Effects of Invention

The present invention can provide: a deposition material which exhibits excellent stability of the deposition rate and an ability to uniformly form a large-area deposition film containing an organic compound, and reduces variation in performance of the resulting organic devices; and a method for producing an organic device using the deposition material. These can solve the above existing problems and achieve the above objects.

### Brief Description of Drawings

Fig. 1 is a cross-sectional view of one exemplary configuration of an organic electroluminescent element.
Fig. 2 is a graph showing changes of luminescence over time of organic electroluminescent elements, where "A" denotes an initial decrease, "B" denotes a curve of an organic electroluminescent element obtained using an deposition material of the present invention, and "C" denotes a curve of an organic electroluminescent element obtained using a conventional deposition material.

### Description of Embodiments

### (Deposition Material for Organic Devices)

A deposition material for organic devices (organic device deposition material or simply deposition material) according to the present invention is a deposition material used for producing an organic device, the deposition material having an average particle diameter of 10 µm to 200 µm where the average particle diameter is expressed by D50% and having a uniformity degree of 1.0 to 4.0 where the uniformity degree is expressed by D60% diameter/D10% diameter. The deposition material is preferably purified through sublimation.

The average particle diameter expressed by D50% is 10 µm to 200 µm, preferably 20 µm to 180 µm, more preferably 40 µm to 150 µm, particularly preferably 50 µm to 120 µm.

When the average particle diameter expressed by D50% is less than 10 µm, static electricity may be caused by aggregation of the particles and increase in contact between the particles, and then it becomes difficult to keep a steady rate of deposition. In contrast, when the average particle diameter is more than 200 µm, variation in deposited amount per unit time may be increased and it becomes difficult to keep a steady rate of deposition.

As used herein, D50% refers to an average particle diameter in which the amount of powder having a particle diameter larger than the average particle diameter D50% is equal to the amount of the powder having a particle diameter smaller than the average particle diameter D50%.

The average particle diameter expressed by D50% (hereinafter also referred to simply as "average particle diameter") may be determined by reading a data point at 50% of percentage passing or cumulative percentage from a grading curve. Plotting the grading curve may be conducted by any method including, but not particularly limited to, a method of sieving a sample to investigate the opening of the sieve, µm, through which the sample is passed and the percentage, %, in which the sample is passed through in order to plot the opening of the sieve as a horizontal axis and the percentage passing as a vertical axis; and a method of determining the cumulative distribution with a laser diffraction particle size analyzer.

The uniformity degree expressed by D60% diameter/D10% diameter (hereinafter also referred to simply as "uniformity degree") is 1.0 to 4.0, preferably 1.0 to 3.5, more preferably 1.0 to 3.2, particularly preferably 1.0 to 3.0.

It is impossible to realize a uniformity degree less than 1.0, in principle. In contrast, when the uniformity degree is more than 4.0, variation in deposited amount per unit time may be increased and it becomes difficult to keep a steady rate of deposition.

As used herein, the D60% diameter refers to a particle diameter at which the percentage passing or the cumulative percentage on a grading curve is 60%, and the D10% diameter refers to a particle diameter at which the percentage passing or the cumulative percentage on a grading curve is 10%.

Measurement of the uniformity degree expressed by D60% diameter/D10% diameter can be conducted by any method including, but not particularly limited to, using a sieving technique or a laser diffraction particle size analyzer to obtain a grading curve and then reading particle diameters at which the percentage passing or the cumulative percentage are 60% and 10% in the resulting grading curve to calculate a ratio of the particle diameter at 60% to the particle diameter at 10% as the uniformity degree.

The method for producing the deposition material having the average particle diameter and the uniformity degree as defined above may be selected appropriately depending on the intended purpose. Examples thereof include, but not particularly limited to, a method in which a material is milled in a mill before sieving it through a mesh with the opening desired to obtain the deposition material with controlled average particle diameter and uniformity degree as described above.

The method for depositing the deposition material includes, but not particularly limited to, the resistance heating method and the flash deposition method, with the flash deposition method being preferred. The deposition material for organic devices can provide a reliable deposition film even when deposited at an increased deposition rate and can be deposited stably for a long period of time because of its superior stability in the deposition rate.

With the flash deposition method, even the deposition material which tends to be decomposed by heating for a long time can be continuously stably deposited without decomposed. Furthermore, the deposition material containing an inorganic oxide can form a film having a composition similar to the deposition material. Any matter which will be described in the section of "Method for Producing Organic Device" can be applied to the flash deposition technique.

The deposition material for organic devices may be selected appropriately depending on the intended purpose without any particular restriction, so long as it meets requirements for the average particle diameter and the uniformity degree as defined above, and includes an organic compound and an inorganic oxide, such as a luminescent material, a host material, a dopant material. Desirable is one which has been subjected to sublimation purification.

Here, the phrase "sublimation purification" refers to one purification procedure to separate a target compound from impurities based on the difference in sublimation temperature therebetween. The manner of the sublimation purification is not particularly limited. Any sublimation purification apparatus can be appropriately selected depending on the production scale and the production conditions. Increased purity of the resulting target compound can be accomplished by flowing a gas and strictly controlling the temperature.

The organic compound may be selected appropriately depending on the intended purpose without any particular restriction, and preferred is a mixture of organic compounds.

### -Luminescent Material-

The luminescent material may be a fluorescent material and a phosphorescent material, as well as a mixture of two or more of them.

In terms of drive durability, the luminescent dopant is preferably a dopant which satisfies the following relationship with respect to the host compound: a difference in ionization potential, ΔIp, 1.2 eV > ΔIp > 0.2 eV, and/or a difference in electron affinity, ΔEa, 1.2 eV > ΔEa > 0.2 eV.

The content of the luminescent dopant in the luminescent layer ranges preferably from 0.1% by mass to 50 % by mass, more preferably from 1% by mass to 50% by mass in terms of external quantum efficiency, particularly preferably from 2 % by mass to 40% by mass, based on the total mass of the compounds which compose the luminescent layer.

### -Phosphorescent Material-

The phosphorescent material may be selected appropriately depending on the intended purpose, including, but not particularly limited to, a complex containing a transition metal atom or a lanthanoid atom.

The transition metal atom may be selected appropriately depending on the intended purpose, including, but not particularly limited to, ruthenium, rhodium, palladium, tungsten, rhenium, osmium, iridium, gold, silver, copper, and platinum. Among them, more preferable are rhenium, iridium and platinum, and particularly preferable are iridium and platinum.

A ligand of the complex may include the ligand described in, for example G. Wilkinson et al, Comprehensive Coordination Chemistry, Pergamon Press (1987); H. Yersin, "Photochemistry and Photophysics of Coordination Compounds," and Springer-Verlag (1987); and Akio Yamamoto, "Organometallic Chemistry-Basis and Application-," SHOKABO PUBLISHING Co., Ltd. (1982).

The complex may contain one transition metal atom, or may contain two or more transition metal atom; i.e., may be a so-called polynuclear complex. The complex may also contain a foreign metal at the same time.

The phosphorescent material may be the phosphorescent material described in, for example US Patent Nos. 6303238 and 6097147; International Publication Nos. WO00/57676, WO00/70655, WO01/08230, WO01/39234, WO01/41512, WO02/02714, WO02/15645, WO02/44189, WO05/19373, WO2004/108857, WO2005/042444 and WO2005/042550; JP-A Nos. 2001-247859, 2002-302671, 2002-117978, 2003-133074, 2002-235076, 2003-123982 and 2002-170684; EP Patent No. 1211257; and JP-ANos. 2002-226495, 2002-234894, 2001-247859, 2001-298470, 2002-173674, 2002-203678, 2002-203679, 2004-357791, 2006-93542, 2006-261623, 2006-256999, 2007-19462, 2007-84635 and 2007-96259.

Among them, preferable are complexes such as Ir complexes, Pt complexes, Cu complexes, Re complexes, W complexes, Rh complexes, Ru complexes, Pd complexes, Os complexes, Eu complexes, Tb complexes, Gd complexes, Dy complexes, and Ce complexes, and particularly preferable are Ir complexes and Pt complexes.

Each of the complexes preferably contains at least one coordination form selected from the group consisting of a metal-carbon bond, a metal-nitrogen bond, a metal-oxygen bond and a metal-sulfur bond, while in terms of luminescent efficiency, drive durability of the organic device, and chromaticity, more preferable is a complex containing a multidentate ligand, such as tridentate or more ligand.

Preferable examples of the Ir complex and the Pt complex are exemplified below.

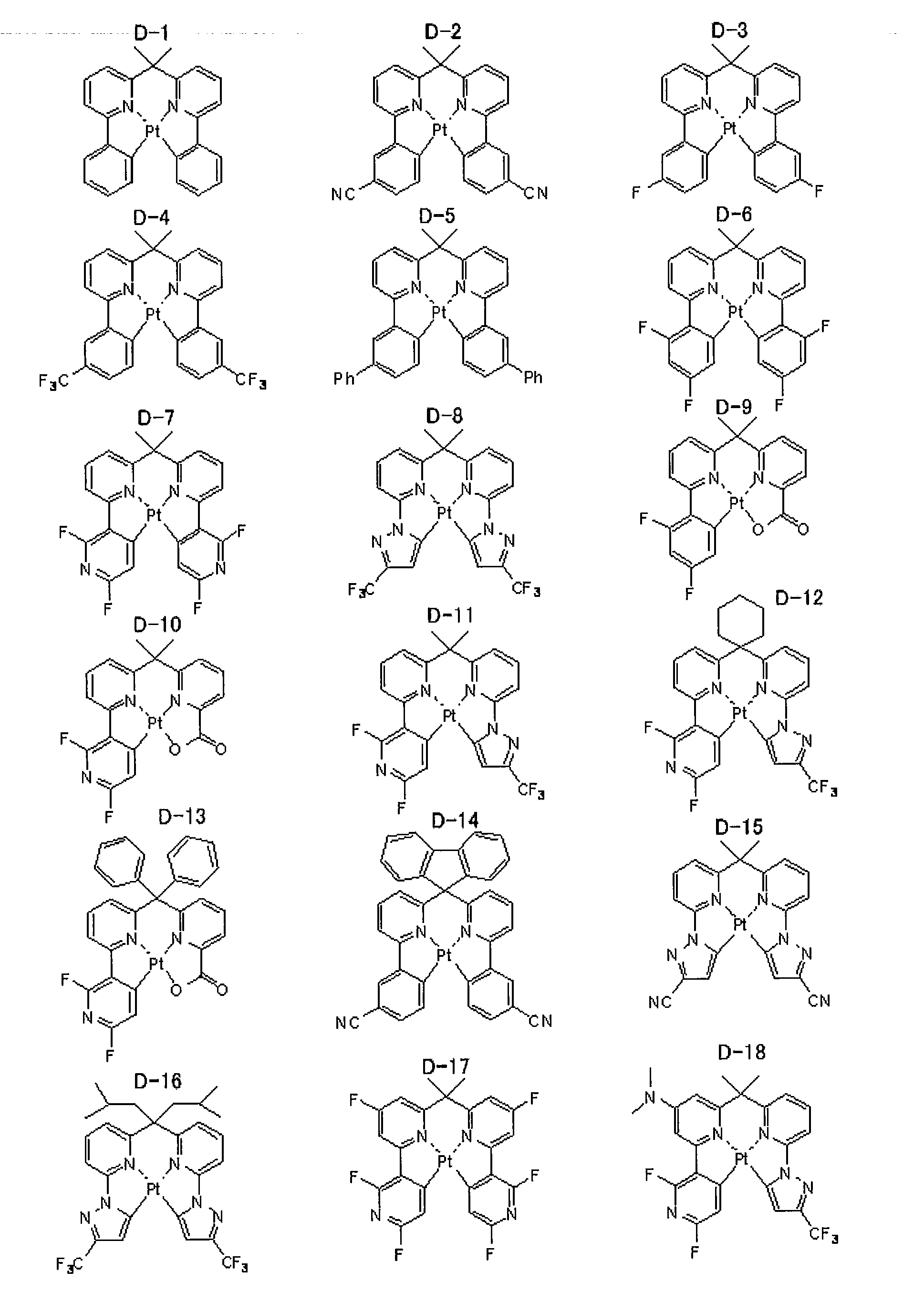

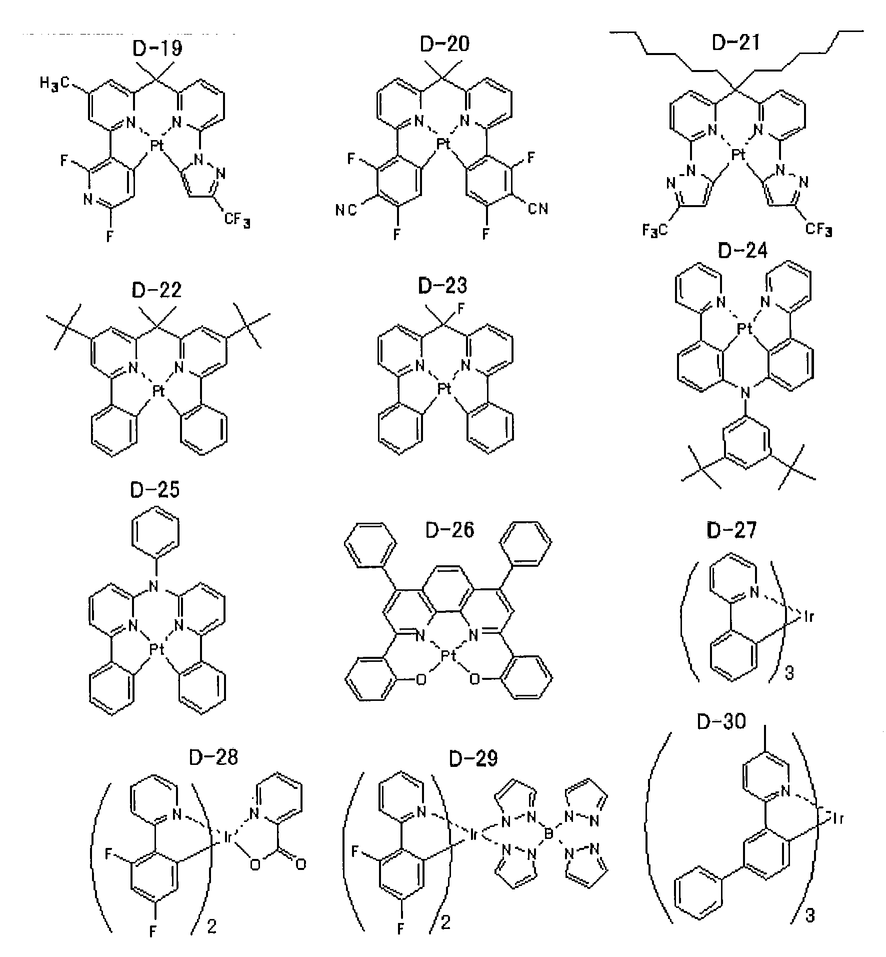

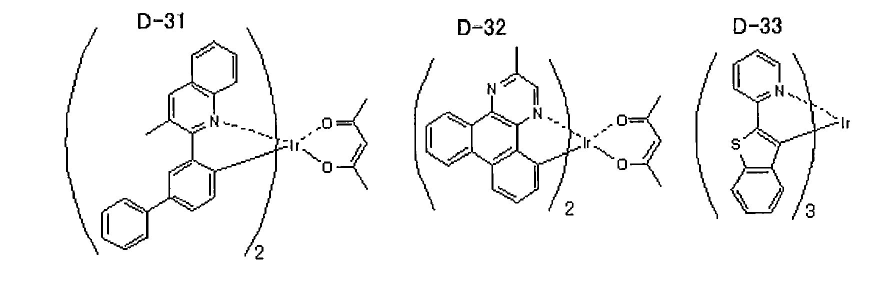

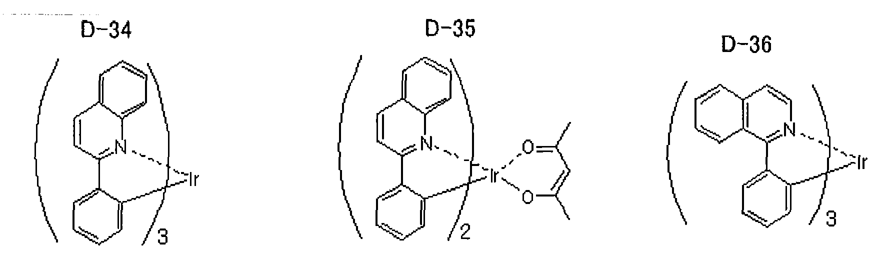

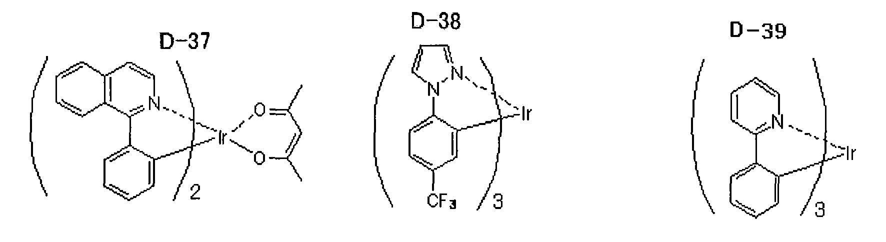

### -Fluorescent Material-

The fluorescent material may be selected appropriately depending on the intended purpose and examples thereof include, but not particularly limited to, benzoxazole, benzoimidazole, benzothiazole, styrylbenzene, polyphenyl, diphenyl butadiene, tetraphenyl butadiene, naphthalimide, coumalin, pyrane, perinone, oxadiazole, aldazine, pyralidine, cyclopentadiene, bis-styrylanthracene, quinacridone, pyrrolopyridine, thiadiazolopyridine, cyclopentadiene, styrylamine, aromatic dimethylidene compounds; fused polycyclic aromatic compounds such as anthracene, phenanthroline, pyrene, perylene, rubrene or pentacene; 8-quinolinol-containing metal complexes; a variety of metal complexes represented by pyrromethene complexes and rare earth metal complexes; polymeric compounds such as polythiophene, polyphenylene, and polyphenylene vinylene; organic silanes, or derivatives thereof. Such fluorescent materials may be used alone or in combination.

### -Host Material-

The host material is preferably a charge transport material. The host materials may be used alone or in combination.

As the host material, a hole transport host material having an excellent hole transporting capability and an electron transport host material having an excellent electron transporting capability may be employed.

### --Hole Transport Host Material--

The hole transport host material may be selected appropriately depending on the intended purpose, including, but not particularly limited to, pyrrole, indole, carbazole, azaindole, azacarbazole, triazole, oxazole, oxadiazole, pyrazole, imidazole, thiophene, polyarylalkane, pyrazoline, pyrazolone, phenylenediamine, arylamine, amino-substituted chalcone, styrylanthracene, fluorenone, hydrazone, stilbene, silazane; aromatic tertiary amine compounds; styrylamine compounds, aromatic dimethylidene compounds; porphyrin compounds; polysilane compounds; poly(N-vinyl carbazole); aniline copolymers; conductive polymers such as thiophene oligomers and polythiophenes; organic silane; carbon films; and derivatives thereof. Such hole transport host materials may be used alone or in combination.

Among them, preferable are indole derivatives, carbazole derivatives, aromatic tertiary amine compounds and thiophene derivatives, more preferable is a compound having a carbazole group in the molecule, and particularly preferable is a compound having a t-butyl-substituted carbazole group in the molecule.

### --Electron Transport Host Material--

The electron transport host material may be selected appropriately depending on the intended purpose, including, but not particularly limited to, pyridine, pyrimidine, triazine, imidazole, pyrazole, triazole, oxazole, oxadiazole, fluorenone, anthraquinodimethane, anthrone, diphenylquinone, thiopyrandioxide, carbodiimide, fluorenylidene methane, distyrylpyrazine, aromatic fluorine-substituted compounds; heterocyclic tetracarboxylic anhydrides such as naphthaleneperylene; phthalocyanine or derivatives thereof (which may form a fused ring with another ring); and a variety of metal complexes represented by metal complexes of 8-quinolinol derivatives, and metal complexes containing metal-phthalocyanine, benzoxazole and benzothiazole as a ligand. Such electron transport host materials may be used alone or in combination.

Among them, preferable are metal complexes in terms of durability, and more preferable are metal complexes containing at least one of nitrogen atom, oxygen atom and sulfur atom as a ligand, which are coordinated at the metal.

Typical examples of the metal complexes include compounds described in, for example, JP-ANos. 2002-235076, 2004-214179, 2004-221062, 2004-221065, 2004-221068, and 2004-327313.

Examples of the hole transport host material and the electron transport host material available for the present invention may include, but not be limited to, the following compounds and their deuterated materials.

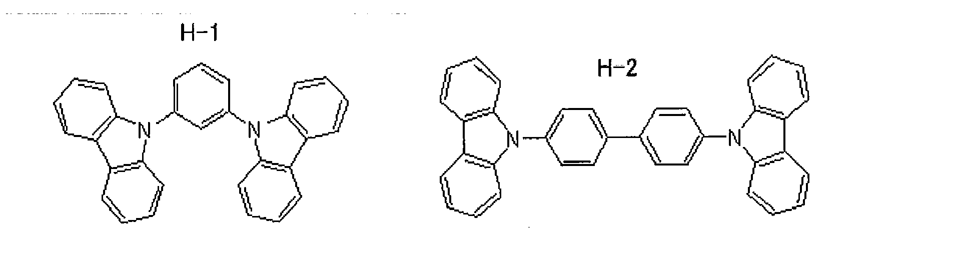

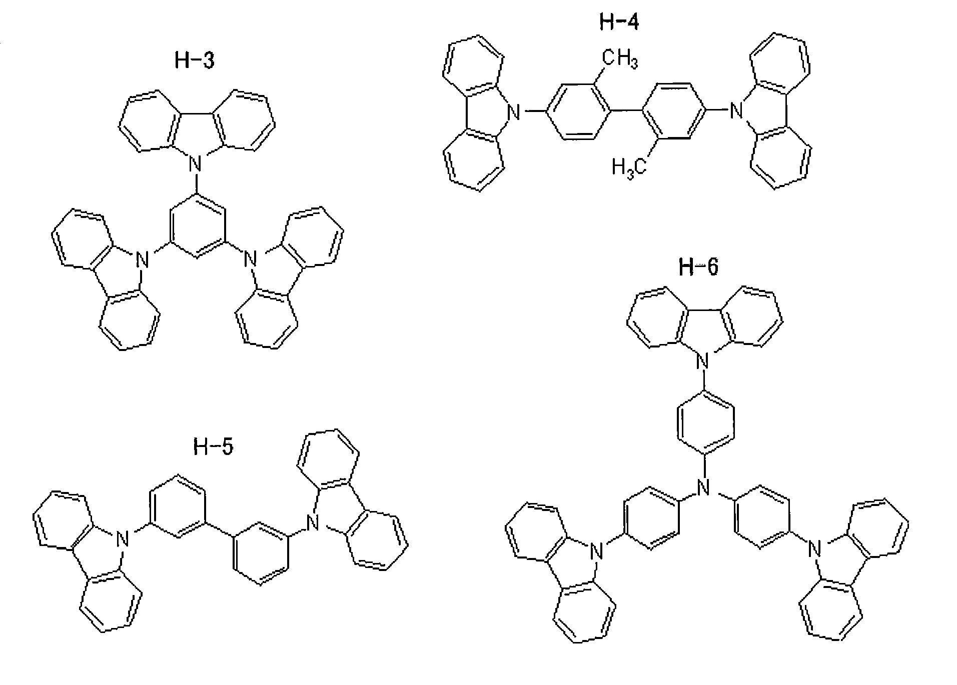

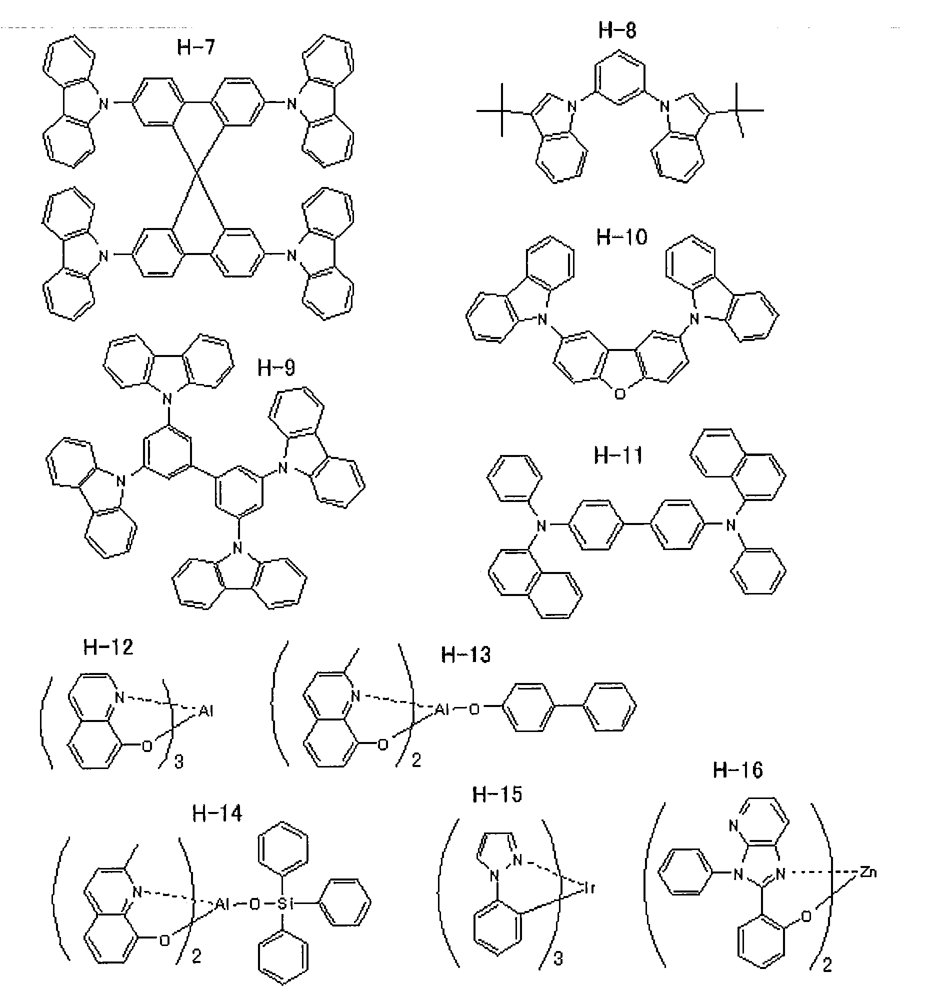

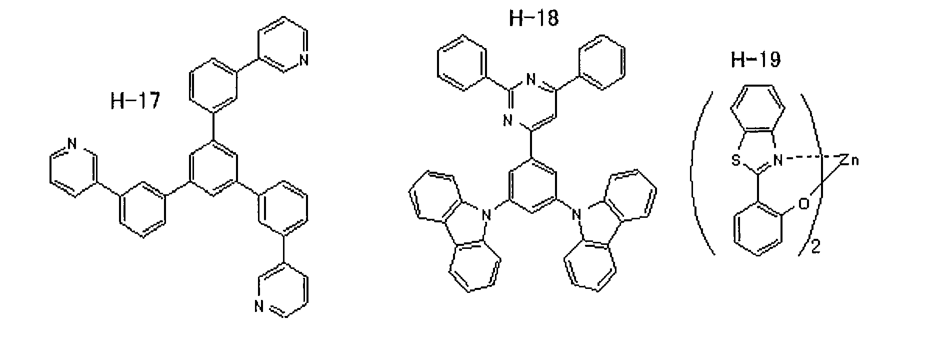

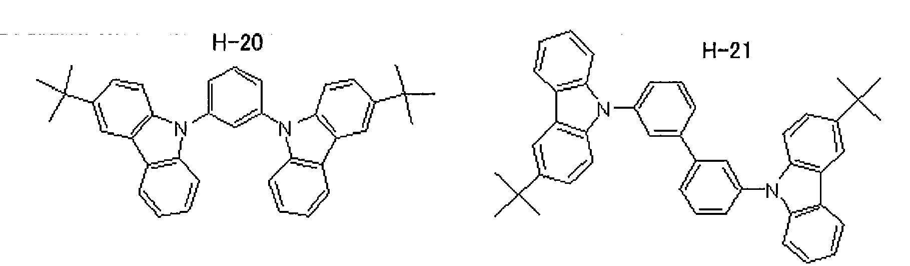

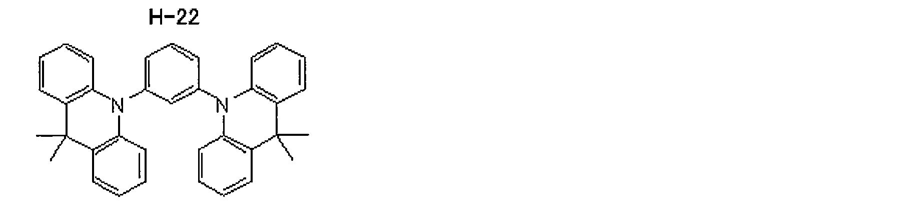

### -Dopant Material-

The dopant material may be selected appropriately depending on the intended purpose without any particular restriction, and be either one of an electron accepting dopant and an electron donating dopant.

Any inorganic compound and any organic compound are available for the electron accepting dopant without any particular restriction, so long as it has electron accepting property and the function of oxidizing an organic compound.

Such inorganic compound may include metal halides, and metal oxides.

The metal halides include ferric chloride, aluminum chloride, gallium chloride, indium chloride, and antimony pentachloride.

The metal oxides include vanadium pentaoxide and molybdenum trioxide (MoO₃).

Examples of the above organic compounds include compounds each having, as a substituent, a nitro group, a halogen atom, a cyano group, and a trifluoromethyl group; quinone compounds; acid anhydrides; and fullerene.

The electron donating dopant preferably include, but not limited to, alkali metals such as Li, alkaline earth metal such as Mg, transition metals including rare earths and organic reductive compounds, as long as it has electron donating ability and an ability to reduce the organic compound. The metal preferably used for the present invention includes metals especially having a work function of 4.2 eV or less, for example Li, Na, K, Be, Mg, Ca, Sr, Ba, Y, Cs, La, Sm, Gd, and Yb. The organic reductive compounds include nitrogen-containing compounds, sulfur-containing compounds, and phosphorus-containing compounds.

Alternately, as examples of a hole-blocking material, aluminum complexes such as BAlq; triazole derivatives; phenanthroline derivatives such as BCP may be included.

### (Method for Producing Organic Device)

A method for producing an organic device according to the present invention includes depositing the deposition material for organic devices according to the present invention described above by using a flash deposition technique to form an organic layer, and the other procedures as necessary.

The flash deposition technique refers to a deposition technique which forms a film while continuously providing the deposition material in a powder form onto a heated portion of a source of the deposition material, having advantages allow the deposition material to prevent decomposition due to mismatched composition of the deposition material and prolonged heating.

The pressure during flash deposition may be selected appropriately depending on the intended purpose without any particular restriction and preferably range from 10⁻¹ Pa to 10⁻⁸ Pa, more preferably from 10⁻³ Pa to 10⁻⁷ Pa, particularly preferably from 10⁻⁴ Pa to 10⁻⁶ Pa.

When the pressure is less than 10⁻⁸ Pa, although it is possible to prevent entrainment of an impurity and an unintended gas, it may require a few days merely to reduce the pressure under vacuum and then result in decreased productivity. When the pressure is more than 10⁻¹ Pa, it may be hard for the deposition material vaporized to be deposited onto a substrate and then extremely decrease utilization efficiency of the deposition material. Alternately, an inert carrier gas, such as nitrogen and argon, can be introduced in order to control a flow of the deposition material vaporized from the source of the deposition material to the substrate.

A heating temperature during the flash deposition may be selected appropriately depending on the deposition material without any particular restriction.

A deposition rate during the flash deposition may be selected appropriately depending on the intended purpose without any particular restriction and preferably range from 0.01 nm/s to 10 nm/s, more preferably from 0.1 nm/s to 5 nm/s, particularly preferably from 0.5 nm/s to 2 nm/s.

When the deposition rate may be less than 0.01 nm/s, it may require time to form a film and then result in decreased productivity. When the deposition rate may be more than 10 nm/s, it may be hard to maintain stability of the deposition rate and to control a film thickness.

As used herein, the unit "nm/s" may be expressed with "angstrom/s," i.e., 0.1 nm/s.

With reference to the deposition rate during the flash deposition, when the deposition rate is represented as v in nm/s, if the lowest observed deposition rate is defined as Vₘᵢₙ in nm/s and the fastest observed deposition rate is defined as Vₘₐₓ in nm/s, then a stability range of the deposition rate defined as Vₘᵢₙ - Vₘₐₓ in nm/s may vary without any particular restriction, for example, preferably from 0 nm/s to 0.3 nm/s, more preferably from 0 nm/s to 0.2 nm/s, particularly preferably 0 nm/s to 0.1 nm/s.

When the stability range of the deposition rate may be more than 0.3 nm/s, producing stability, yield, and device performance can be deteriorated.

The other procedures may be selected appropriately depending on the intended purpose without any particular restriction, including any procedure employed in the known producing method for organic devices in the art.

Use of the deposition material for organic devices may uniformly form a large-area film containing an organic compound with excellent stability of the deposition rate, while reducing variation in performance of the organic devices, and therefore be suitably for the production of an organic electroluminescent device, an organic thin film solar cell, and an organic field-effect transistor.

Among the organic devices, it can be particularly preferably applied to the organic electroluminescent device.

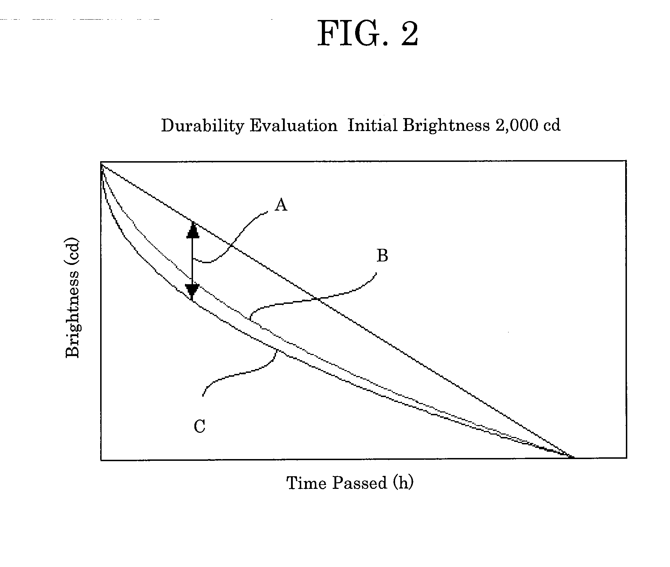

Typically, the organic electroluminescent device requires high brightness because its reduced brightness over time may be found. Especially, there has been found in a conventional electroluminescent device to be logarithmically deteriorated brightness over time, i.e. initial decrease, and then to early result in significantly reduced brightness (see Fig. 2). It becomes a major issue regarding a quality of the organic device.

However, the electroluminescent device, in which the organic layer is formed by using the deposition material for organic devices according to the present invention, can suppress the initial decrease (see Fig. 2).

The reason is because although when increasing variation in deposition rate, a mixing ratio of a concentration of a guest material and a concentration of a host material may deviate from a set value especially in the luminescent layer so that it is impossible to accomplish the expected durability, a high performance organic device can be provided in higher yield by exactly controlling the deposition rate stably using the method according to the present invention.

In a preferred aspect of the organic device produced using the deposition material for organic devices according to the present invention, the organic electroluminescent device will be explained hereinafter.

### (Organic Electroluminescent Material)

The organic electroluminescent device may contain at least one organic layer between a pair of electrodes, and the organic layer may be made of the deposition material for organic devices according to the present invention.

Configuration of the organic layer may be selected appropriately depending on the intended purpose without any particular restriction and include a luminescent layer, a hole injection layer, a hole transport layer, an electron injection layer, an electro transport layer, a hole blocking layer, an electron blocking layer and further contain the other layers as necessary.

### <Luminescent Layer>

The luminescent layer is a layer having a function to accept a hole from an anode, a hole injection layer and a hole transport layer, while accepting an electron from a cathode, an electron injection layer and an electron transport layer, serving as a site to recombine the hole and the electron so as to emit light.

The luminescent layer may be composed of the luminescent material and additionally the host material described above. Namely, the luminescent layer may be composed of the luminescent material alone or in combination with the host material to form a mixed layer.

Further, the luminescent layer may have no charge transport property in itself or may contain a non-luminescent material therein.

A thickness of the luminescent layer may be selected appropriately depending on the intended purpose without any particular restriction and range preferably from 2 nm to 500 nm, more preferably from 3 nm to 200 nm in terms of external quantum efficiency, particularly preferably from 5 nm to 100 nm. Further, there may be existed in one or two or more luminescent layer(s), and furthermore the luminescent layers may emit light in different luminescent colors, respectively.

### <Hole Injection Layer and Hole Transport Layer>

Each of the hole injection layer and the hole transport layer is a layer having a function to accept a hole from any one of an anode and an anode side and then to transport the hole to an cathode side.

Each of the hole injection layer and the hole transport layer may be composed of the hole transport host material and the electron accepting dopant described above.

The thickness of each of the hole injection layer and the hole transport layer may be selected appropriately depending on the intended purpose without any particular restriction and range preferably from 1 nm to 500 nm, more preferably from 5 nm to 200 nm, particularly preferably from 10 nm to 100 nm.

Each thickness of the hole injection layer and the hole transport layer may be in a single layer structure composed of one or two or more materials, or in a multilayer structure composed of multiple layers having one of the same composition and the different compositions.

### <Electron Injection Layer and Electron Transport Layer>

Each of the electron injection layer and the electron transport layer is a layer having a function to accept a hole from any one of a cathode and a cathode side and then to transport the hole to an anode side.

The electron transport layer may be composed of the electron transport host material and the electron donating dopant described above.

Each thickness of the electron injection layer and the electron transport layer may be selected appropriately depending on the intended purpose without any particular restriction, and is preferably 500 nm or less in terms of decreased drive voltage.

The thickness of the electron transport layer may range preferably from 1 nm to 500 nm, more preferably from 5 nm to 200 nm, particularly preferably from 10 nm to 100 nm.

The thickness of the electron injection layer may range preferably from 0.1 nm to 200 nm, more preferably from 0.2 nm to 100 nm, particularly preferably from 0.5 nm to 50 nm.

Each of the electron injection layer and the electron transport layer may be in a single layer structure composed of one or two or more materials, or in a multilayer structure composed of multiple layers having one of the same composition and the different compositions.

### <Hole Blocking Layer>

The hole blocking layer is a layer having a function to block the hole transformed from the anode side to the luminescent layer form passing to the cathode side. The hole blocking layer can be provided as an organic layer adjacent to the luminescent layer at the cathode side.

The hole blocking layer may be composed of the hole blocking material described above.

A thickness of the hole blocking layer may be selected appropriately depending on the intended purpose without any particular restriction and range preferably from 1 nm to 500 nm, more preferably from 5 nm to 200 nm, particularly preferably from 10 nm to 100 nm.

The hole blocking layer may be in a single layer structure composed of one or two or more materials, or in a multilayer structure composed of multiple layers having one of the same composition and the different compositions.

### <Electron Blocking Layer>

The electron blocking layer is a layer having a function to block the electron transformed from the cathode side to the luminescent layer form passing to the anode side, and it can be usually provided as an organic layer adjacent to the luminescent layer at the anode side.

The electron blocking layer may be composed of the hole transport dopant described above.

A thickness of the electron blocking layer may be selected appropriately depending on the intended purpose without any particular restriction and range preferably from 1 nm to 500 nm, more preferably from 5 nm to 200 nm, particularly preferably from 10 nm to 100 nm. In addition, the electron blocking layer may be in a single layer structure composed of one or two or more material(s), or in a multilayer structure composed of multiple layers having one of the same composition and the different compositions.

### <Electrode>

The organic electroluminescent device includes the anode and the cathode as a pair of electrodes. In view of the characteristics of the organic electroluminescent device, at least one of the anode and the cathode is preferably transparent. In general, while the anode may merely serve as the electrode to provide the hole to the organic layer, the cathode may merely serve as the electrode to inject the electron to the organic layer.

For the electrode, its configuration, conformation, and size are not particularly limited and appropriately selected from the electrode material known in the art depending on the use and the purpose of the organic electroluminescent device.

Examples for a material composing the electrode preferably include metals, alloys, metal oxides, conductive compounds, or a mixture thereof.

### -Anode-

An example for a material composing the anode includes conductive metal oxides such as tine oxide doped with antimony or fluorine (ATO, FTO), tin oxide, zinc oxide, indium oxide, indium tin oxide (ITO) and indium zinc oxide (IZO); metals such as gold, silver, chrome and nickel; mixtures or laminates of the metals and the conductive metal oxides; inorganic conductive materials such as copper iodide and copper sulfide; organic conductive materials such as polyaniline, polythiophene and polypyrrole; or laminates thereof with ITO. Among them, preferred is the conductive metal oxides, and most preferred is ITO in terms of productivity, higher conductive property, and transparency.

### -Cathode-

An example for a material composing the cathode includes alkali metals such as Li, Na, K, Cs, etc.; alkali earth metals such as Mg, Ca, etc.; rare-earth metals such as gold, silver, zinc, aluminum, sodium-potassium alloys, lithium-aluminum alloys, magnesium-silver alloys, indium, and ytterbium. The material may be used alone, but in terms of the balance of stability and electron injection performance, two or more of the materials can be suitably used in combination.

Among them, alkali metals and alkali earth metals are preferred in terms of electron injection performance, and most preferred is a material primarily composed of aluminum in view of superior preservation stability.

The material primarily composed of aluminum refers to aluminum alone, alloys or mixtures of aluminum with 0.01 % by mass to 10 % by mass of an alkali metal or an alkaline earth metal, such as lithium-aluminum alloys and magnesium-aluminum alloys.

Production of the electrode may be conducted without any particular restriction by the techniques known in the art, including wet processes such as a printing method and a coating method, etc.; physical systems such as a vacuum deposition method, a sputtering technique, ion plating, etc.; chemical processes such as CDV, plasma CVD, etc. The electrode may be formed on the substrate according to the technique appropriately selected from the techniques in view of proper balance with the material composing the electrode. For example, when selecting ITO as the anode material, the electrode can be formed by DC sputtering technique or high-frequency sputtering technique, vacuum deposition method, or ion plating. Alternatively, when selecting metal as the cathode material, one or two or more of the cathode material may be employed simultaneously or successively according to the sputtering technique to form the electrode.

Additionally, when forming the electrode with patterning, it can be conducted by any chemical etching technique, such as photolithography, or any physical etching technique using laser, or alternately, it can be also conducted by applying a mask thereon according to the vacuum deposition method or the sputtering technique, or a liftoff technique or the printing method.

### <Substrate>

Preferably, the organic electroluminescent device is provided on the substrate, while the electrode and the substrate may be directly connected with together or provided via an intermediate layer.

The material suitable for the substrate may be selected appropriately depending on the intended purpose without any particular restriction, and examples thereof include inorganic materials, polyester resins, and organic materials.

Examples of the inorganic materials include yttria-stabilized zirconia (YSZ); and glass such as an alkali-free glass, and a soda-lime glass.

Examples of the polyester resins include polyethylene terephthalates, polybutylene phthalates, and polyethylene naphthalates.

Examples of the organic material include polystyrenes, polycarbonates, polyethersulfones, polyarylates, polyimides, polycycloolefins, norbornene resins, and poly(chlorotrifluoroethylene).

For the substrate, its shape, structure, and size are not particularly limited and appropriately selected depending on the use and the purpose of the luminescent device. The substrate is preferably in the form of plate. The substrate may be conformed in a single layer structure or a multilayer structure, and also composed of a single component or two or more components. Further, the substrate may be transparent or opaque, and for the transparent substrate, it may be opaque, colorless transparent or colored transparent.

The substrate can be provided with a vapor resistance layer, i.e. a gas barrier layer, on any one of its surface and its opposed side.

A material suitable for the vapor resistance layer, i.e. the gas barrier layer, includes, for example, inorganic materials such as silicon nitrides and silicon oxides.

The vapor resistance layer, i.e. the gas barrier layer, may be formed by using a high-frequency sputtering technique.

### -Other Components-

The other components composing the organic electroluminescent device according to the present invention may be selected appropriately depending on the intended purpose without any particular restriction, including a passivation layer, a sealed container, a resin seal layer, and a sealant.

The passivation layer, the sealed container, the resin seal layer, the sealant may be selected appropriately depending on the intended purpose without any particular restriction and be provided as disclosed in, for example, JP-A No. 2009-152572.

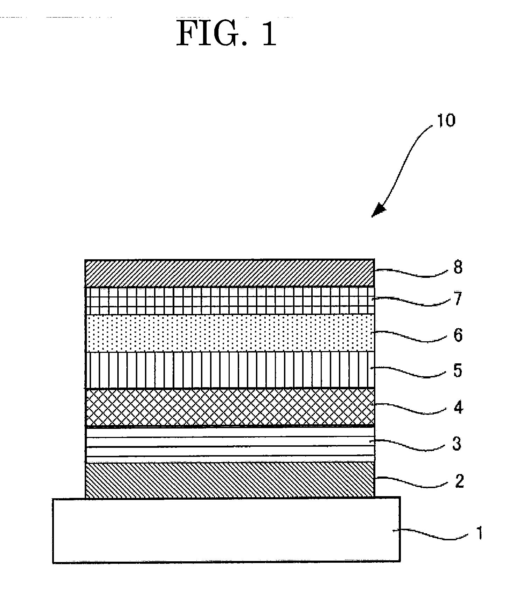

Fig. 1 is a schematic view of one exemplary layer configuration in the organic electroluminescent device according to the present invention. The organic electroluminescent element 10 has the layer structure where an anode 2 (e.g., ITO electrode) formed on a glass substrate 1, a hole injection layer 3, a hole transport layer 4, a luminescent layer 5, an electron transport layer 6, an electron injection layer 7 and a cathode 8 (e.g., Al-Li electrode) are laminated in this order. Notably, the anode 2 (e.g., ITO electrode) and the cathode 8 (e.g., Al-Li electrode) are connected together via a power source.

### -Driving-

The organic electroluminescent device can achieve luminescence by applying DC (which may include AC component, as necessary) voltage, typically 2 volts to 15 volts or DC electricity between the anode and the cathode.

The organic electroluminescent device can be applied to an active matrix approach using a thin film transistor (TFT). As an active layer in the thin film transistor, amorphous silicon, high-temperature polysilicon, low-temperature polysilicon, microcrystalline polysilicon, an oxide semiconductor, an organic semiconductor, or carbon nanotube is available.

To the organic electroluminescent device of the present invention, the thin film transistor described in, for example, International Publication No. WO2005/088726, JP-A No. 2006-165529, and US Patent Application Publication No. 2008/0237598A1 can be employed.

Improvement in light extraction efficiency of the organic electroluminescent device can be achieved without any particular restriction by means of a variety of ingenuities known in the art. For example, processing a surface profile of the substrate (e.g., forming a fine textured pattern); controlling refractive indices of the substrate, ITO layer and the organic layer such as the luminescent layer; and controlling each thickness of the substrate, ITO layer and the organic layer such as the luminescent layer may result in improved light extraction efficiency and increased external quantum efficiency.

The light extraction efficiency from the organic electroluminescent device of the present invention may be achieved via either a top emitting approach or a bottom emitting approach.

The organic electroluminescent device may include a resonator structure. For example, onto the transparent substrate, a multilayer mirror composed of plural of laminated films having different refractive indices, a transparent or opaque electrode, the luminescent layer and the metal electrode are laminated in turn. Each of the multilayer mirror and the metal electrode may act as reflectors to repeatedly reflect the light from the luminescent layer to induce optical resonance between them (the first aspect).

In the second aspect, onto the transparent substrate, each of the transparent or opaque electrode and the metal electrode may act as reflectors to repeatedly reflect the light from the luminescent layer to induce optical resonance between them.

To form the optical resonance structure, each optical path length determined by effective refractive indices of the two reflectors and each refractive index and each thickness of layers between the reflectors should be controlled to the optimal value for purchasing the desired resonance wavelength.

In the first aspect, one example of a formula for estimating the optimal value described in JP-A No. 09-180883.

In the second aspect, one example of a formula for estimating the optimal value has been described in JP-A No. 2004-127795.

### -Application-

The organic electroluminescent device of the present invention may be selected appropriately depending on the intended purpose, and suitably used for, e.g., a display element, a display, a backlight, an electrophotograph, an illuminated light source, a recording light source, an exposing source, a reading light source, a label, an advertising display, an interior decorating, and optical communication. Some methods for configuring the full color organic electroluminescent (EL) display have been known as described in, for example, "Monthly Display," September 2000, pp. 33 to 37, including a trichromatic emission method to provide on the substrate the organic electroluminescent devices which emits lights corresponding to three primary colors (i.e., blue (B), green (G) and red (R)), respectively; a white light emission method to divide a white light emitted from a white light-emitting organic electroluminescent device through a color filter into three primary colors; a color conversion method to conversion a blue luminescence from a blue light-emitting organic electroluminescent device through a fluorochrome layer into red (R) and green (G). Some organic electroluminescent devices obtained by using the above methods, which emit different emission lights, may be combined to make a flat-type light source as desired, including a white light source made by combining a blue light emitting element and a yellow light emitting element; another white light source made by combining a blue light emitting element, a green light emitting element and a red light emitting element.

### Examples

The present invention will next be described in detail by way of Examples, which should not be construed as limiting the present invention thereto.

### [Production Example 1: Examples 1 to 6 and Comparative Examples 1 to 7]

A compound (A) having the following structural formula serving as a host material, was subjected to sublimation purification using a sublimation purification apparatus (trade name P-100, ALS Technology Co., Ltd.). The resultant product was collected and milled in Super mass colloider (MKCA6-2) with varying a gap between grind stones to make powder having an average particle diameter of about 1,500 µm to about 20 µm.

To prepare powder having a smaller particle diameter, the powder was further milled using a dry jet mill (NJ-50) to make powder having an average particle diameter of about 20 µm to about 1 µm.

The resulting powder having an average particle diameter of about 1,500 µm to about 1 µm was gradually sieved through meshes having sieve openings between 1,520 µm and 1 µm as described below to obtain deposition materials for organic devices of Examples 1 to 6 and Comparative Examples 1 to 7, having an average particle diameter (D50%) and a uniformity degree (D60% diameter/D10% diameter) shown in Table 1.
· Sieve opening: between 1,520 µm and 20 µm
   A stainless mesh (product of Semitec Corporation)
· Sieve opening: between 15 µm and 1 µm
   A nylon mesh (NYTAL, product of Semitec Corporation)

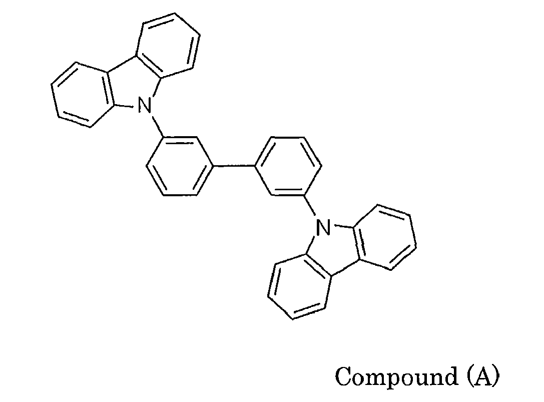

### (Measurement of Particle Diameter and Uniformity Degree)

The average particle diameter (D50%) and the uniformity degree (D60% diameter/D10% diameter) of the deposition materials for organic devices according to Examples 1 to 6 and Comparative Examples 1 to 7 were measured using a laser diffraction/scattering particle size analyzer (Microtrac MT3000II, product of Nikkiso Co., Ltd.). The results are shown in Table 1.

### (Method for Determining Deposition Rate and Evaluation of Deposition Rate Stability)

Measurement of the deposition rate of the deposition materials for organic devices according to Examples 1 to 6 and Comparative Examples 1 to 7 was conducted using a vacuum deposition apparatus (product of Tokki Corporation) with an impeller by dropping the deposition materials for organic devices at a constant rate onto a flash deposition member within a vacuum chamber, depositing the deposition materials for organic devices from the flash deposition member onto the substrate and determining using a film thickness monitor (CRTM-9000, product of Ulvac, Inc.) the deposition rate of the deposition materials for organic devices depositing on a crystal oscillator located at the same distance apart from the flash deposition member as that from the flash deposition member to the substrate when deposited at a deposition rate of 12.0 angstrom/s (= 1.2 nm/s) to record the minimum and the maximum of the deposition rate in a stable state.

In addition, evaluation of the deposition rate stability was performed by determining the difference between the minimum and the maximum of the deposition rate to evaluate the difference according to the following criteria. The results are shown in Table 1.

### <Evaluation Criteria of Deposition Rate Stability>

A: 2 angstrom/s or less
B: 2 angstrom/s to 3 angstrom/s
C: More than 3 angstrom/s

### (Production of Organic Electroluminescent Element of Production Example 1)

A glass substrate, 0.5 mm thickness and 2.5 cm x 2.5 cm, was placed in a washing case, where it was ultrasonically washed in 2-propanol. The thus-washed glass substrate was subjected to UV-ozone treatment for 30 minutes. Onto the resulting glass substrate, each layer described below was formed by vacuum deposition method. Unless otherwise specified, the organic materials were vapor deposited by the flash deposition method. Also, the deposition rate in Examples and Comparative Examples was 1.2 nm/s unless otherwise specified. Measurement of the deposition rate was conducted using the crystal oscillator.

### <Anode>

Onto the glass substrate, ITO (Indium Tin Oxide) was deposited through sputtering to have a thickness of 100 nm.

### <Hole Injection Layer>

On the anode (ITO), 2-TNATA
(4,4',4"-Tris(N-(2-naphtyl)-N-phenyl-amino)-triphenylamine) and 1 % by mass of F4-TCNQ (2,3,5,6-tetrafluoro-7,7,8,8-tetracyanoquinodimethane) serving as a dopant were co-deposited to form a hole injection layer having a thickness of 120 nm.

### <First Hole Transport Layer>

On the hole injection layer, α-NPD (bis[N-(1-naphtyl)-N-phenyl]benzidine) was deposited to form a first hole transport layer having a thickness of 7 nm.

### <Second Hole Transport Layer>

On the first hole transport layer, the hole transport material 1 having the following structural formula was deposited to form a second hole transport layer having a thickness of 3 nm.

### -Hole transport material 1-

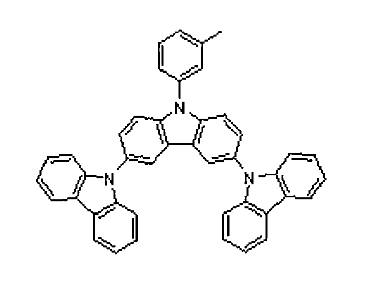

### <Luminescent Layer>

On the second hole transport layer, a 30 nm-thick luminescent layer was formed through deposition containing the compound (A) produced in Example 1 as a host material and doped with a phosphorescent material Ir(ppy) (tris(2-phenylpyridine)-iridium), serving as a guest material, in an amount of 10 % by mass relative to the amount of the host material.

### <Electron Transport Layer>

On the luminescent layer, BAlq
(bis-(2-methyl-8-quinolinolato)-4-(phenyl-phenolate)-aluminum (III)) was deposited to form an electron transport layer having a thickness of 30 nm.

### <Electron Injection Layer>

On the electron transport layer, LiF was deposited to have a thickness of 1 nm.

### <Cathode>

On the electron injection layer, a mask patterned appropriately for the cathode (the mask giving a luminescent region of 2 mm x 2 mm) was placed before depositing metal aluminum to attain a thickness of 100 nm to form a cathode.

The thus-produced laminate was placed in a glove box purged with argon gas and then sealed using a stainless seal can with an ultraviolet curable sealant (XNR5516HV, Nagase-Ciba Ltd.) Through the above procedure, an organic electroluminescent element of Example 1 was produced.

Organic electroluminescent elements of Examples 2 to 6 and Comparative Examples 1 to 7 were produced in the same manner as in Example 1, except that deposition materials for organic devices containing compound (A) varied in average particle diameter and uniformity degree were used as the host material for the luminescent layer.

### <Measurement of Initial Decrease>

Each organic electroluminescent element was evaluated using a source measure unit 2400 (product of Toyo Corporation) by applying DC voltage so as to attain a brightness of 2,000 cd/m² according to the following criteria:
A: the time required for 10% reduction of the brightness was equal to or more than 1/10 of the half-life of luminescence; and
B: the time required for 10% reduction of the brightness was less than 1/10 of the half-life of luminescence. The results are shown in Table 1.

### <Evaluation of Film Uniformity>

On a 20 cm x 20 cm glass substrate, the compound (A) different in average particle diameter and uniformity degree was used as the deposition material for Examples 2 to 6 and Comparative Examples 1 to 7, to form a film by flash deposition, and then the thickness of the resulting film of the compound (A) on the glass substrate was measured both in the central area of the substrate and on the periphery of the substrate on Stylus Surface Profiler (DEKTAK6M) to calculate the difference therebetween and then evaluated according to the following criteria:
A: the difference was 5% or less; and
B: the difference was more than 5%. The results are shown in Table 1.

**Table 1**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 1 | 10 | 1.9 | 11.6 to 12.3 | 0.7 | A | A | A |
| Ex. 2 | 42 | 2.2 | 11.7 to 12.4 | 0.7 | A | A | A |
| Ex. 3 | 101 | 2.3 | 11.7 to 12.4 | 0.7 | A | A | A |
| Ex. 4 | 103 | 3.6 | 11.5 to 12.5 | 1.0 | A | A | A |
| Ex. 5 | 152 | 2.2 | 11.6 to 12.4 | 0.8 | A | A | A |
| Ex. 6 | 200 | 2.1 | 11.5 to 12.4 | 0.9 | A | A | A |
| Comp. Ex. 1 | 1 | 1.8 | 10.5 to 13.4 | 2.9 | B | B | B |
| Comp. Ex. 2 | 6 | 2.0 | 10.8 to 13.1 | 2.3 | B | B | B |
| Comp. Ex. 3 | 285 | 2.3 | 10.3 to 13.7 | 3.4 | C | B | B |
| Comp. Ex. 4 | 522 | 2.6 | 10.2 to 13.8 | 3.6 | C | B | B |
| Comp. Ex. 5 | 1,015 | 2.4 | 9.1 to 14.8 | 5.7 | C | B | B |
| Comp. Ex. 6 | 44 | 4.3 | 10.4 to 13.5 | 3.1 | C | B | B |
| Comp. Ex. 7 | 100 | 4.8 | 9.6 to 14.1 | 4.5 | C | B | B |

| | | | | | | | |
|---|---|---|---|---|---|---|---|
| In Table 1, angstrom/s means 0.1 nm/s. | | | | | | | |

### [Production Example 2: Examples 7 to 9 and Comparative Examples 8 to 11]

Organic device deposition materials for Examples 7 to 9 and Comparative Examples 8 to 11 shown in Table 2 were produced in the same manner as in Production Example 1, except that the compound (A) serving as the host material was changed to a luminescent material of compound (B) having the following structural formula (Production Example 2).

Measurement of the average particle diameter and the uniformity degree, as well as the deposition rate, and evaluation of the deposition rate stability were conducted in the same manner as performed for the organic device deposition materials of Production Example 1. The results are shown in Table 2.

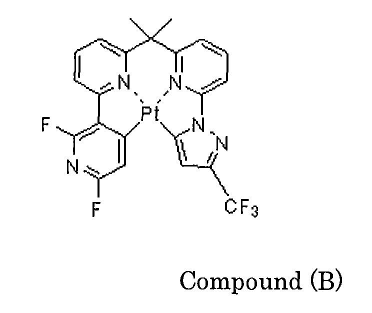

### (Production of Organic Electroluminescent Elements of Production Example 2)

Organic electroluminescent elements of Examples 7 to 9 and Comparative Examples 8 to 11 were produced in the same manner as in Production Example 1, except that mCP (bis-carbazole benzene) was used as the host material, and the organic device deposition materials containing the compound (B), serving as the luminescent material, varied in average particle diameter and uniformity degree for Examples 7 to 9 and Comparative Examples 8 to 11 were used as the deposition material.

The resulting organic electroluminescent elements were evaluated for initial decrease and film forming uniformity in the same manner as in Production Example 1. The results are shown in Table 2.

**Table 2**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 7 | 12 | 2.6 | 11.5 to 12.5 | 1.0 | A | A | A |
| Ex. 8 | 100 | 2.4 | 11.7 to 12.3 | 0.6 | A | A | A |
| Ex. 9 | 196 | 2.1 | 11.3 to 12.8 | 1.5 | A | A | A |
| Comp. Ex. 8 | 5 | 2.2 | 10.8 to 13.1 | 2.3 | B | B | B |
| Comp. Ex. 9 | 264 | 2.3 | 10.6 to 13.5 | 2.9 | B | B | B |
| Comp Ex. 10 | 622 | 2.6 | 9.4 to 14.2 | 4.8 | C | B | B |
| Comp Ex. 11 | 103 | 5.1 | 9.3 to 14.6 | 5.3 | C | B | B |

| | | | | | | | |
|---|---|---|---|---|---|---|---|
| In Table 2, angstrom/s means 0.1 nm/s. | | | | | | | |

### [Production Example 3: Examples 10 to 12 and Comparative Examples 12 to 15]

Organic device deposition materials for Examples 10 to 12 and Comparative Examples 12 to 15 shown in Table 3 were produced in the same manner as in Production Example 1, except that the compound (A) serving as the host material was changed to a luminescent material of compound (C) having the following structural formula (Production Example 3).

Measurement of the average particle diameter and the uniformity degree, as well as the deposition rate, and evaluation of the deposition rate stability were conducted in the same manner as performed for the organic device deposition materials of Production Example 1. The results are shown in Table 3.

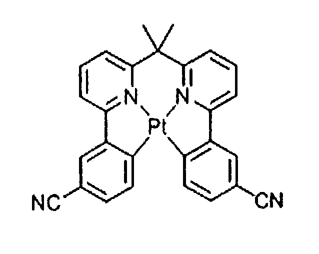

### Compound (C)

### (Production of Organic Electroluminescent Elements of Production Example 3)

Organic electroluminescent elements of Examples 10 to 12 and Comparative Examples 12 to 15 were produced in the same manner as in Production Example 2, except that the organic device deposition materials containing the compound (C), serving as the luminescent material, varied in average particle diameter and uniformity degree for Examples 10 to 12 and Comparative Examples 12 to 15 were used as the deposition material.

The resulting organic electroluminescent elements were evaluated for initial decrease and film forming uniformity in the same manner as in Production Example 1. The results are shown in Table 3.

**Table 3**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 10 | 11 | 2.5 | 11.4 to 12.6 | 1.2 | A | A | A |
| Ex. 11 | 102 | 2.5 | 11.6 to 12.5 | 0.9 | A | A | A |
| Ex. 12 | 197 | 2.0 | 11.3 to 12.7 | 1.4 | A | A | A |
| Comp. Ex. 12 | 6 | 2.4 | 10.8 to 13.1 | 2.3 | B | B | B |
| Comp. Ex. 13 | 271 | 2.4 | 10.9 to 13.2 | 2.3 | B | B | B |
| Comp Ex. 14 | 534 | 2.6 | 9.3 to 14.5 | 5.2 | C | B | B |
| Comp Ex. 15 | 101 | 4.7 | 9.5 to 14.6 | 5.1 | C | B | B |

| | | | | | | | |
|---|---|---|---|---|---|---|---|
| In Table 3, angstrom/s means 0.1 nm/s. | | | | | | | |

### [Production Example 4: Examples 13 to 15 and Comparative Examples 16 to 19]

Organic device deposition materials for Examples 13 to 15 and Comparative Examples 16 to 19 shown in Table 4 were produced in the same manner as in Production Example 1, except that commercially available molybdenum trioxide (MoO₃, product of Furuuchi Chemical Corporation) having a particle diameter appropriately selected from a range of about 0.5 µm to about 900 µm was used instead of the milled compound (A) serving as the host material (Production Example 4).

Measurement of the average particle diameter and the uniformity degree, as well as the deposition rate, and evaluation of the deposition rate stability were conducted in the same manner as performed for the organic device deposition materials of Production Example 1. The results are shown in Table 4.

### (Production of Organic Electroluminescent Elements of Production Example 4)

Organic electroluminescent elements of Examples 13 to 15 and Comparative Examples 16 to 19 were produced in the same manner as in Production Example 1, except that mCP (bis-carbazole benzene) was used as the host material, and organic device deposition materials containing molybdenum trioxide, serving as the dopant of the hole injection layer, varied in average particle diameter and uniformity degree for Examples 13 to 15 and Comparative Examples 16 to 19 were used as the deposition material.

The resulting organic electroluminescent elements were evaluated for initial decrease and film forming uniformity in the same manner as in Production Example 1. The results are shown in Table 4.

**Table 4**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 13 | 13 | 2.7 | 11.1 to 12.9 | 1.8 | A | A | A |
| Ex. 14 | 106 | 2.8 | 11.0 to 12.9 | 1.9 | A | A | A |
| Ex. 15 | 190 | 2.7 | 11.2 to 12.8 | 1.6 | A | A | A |
| Comp. Ex. 16 | 5 | 2.9 | 10.6 to 13.5 | 2.9 | B | B | B |
| Comp. Ex. 17 | 279 | 2.9 | 10.2 to 13.8 | 3.6 | C | B | B |
| Comp Ex. 18 | 504 | 2.7 | 9.2 to 14.8 | 5.6 | C | B | B |
| Comp Ex. 19 | 119 | 5.3 | 9.0 to 15.1 | 6.1 | C | B | B |

| | | | | | | | |
|---|---|---|---|---|---|---|---|
| In Table 4, angstrom/s means 0.1 nm/s. | | | | | | | |

### [Production Example 5: Examples 16 to 18 and Comparative Examples 20 to 23]

Organic device deposition materials for Examples 16 to 18 and Comparative Examples 20 to 23 shown in Table 5 were produced in the same manner as in Production Example 1, except that the compound (A) serving as the host material was changed to a luminescent material of compound (D) having the following structural formula (Production Example 5).

Measurement of the average particle diameter and the uniformity degree, as well as the deposition rate, and evaluation of the deposition rate stability were conducted in the same manner as performed for the organic device deposition materials of Production Example 1. The results are shown in Table 5.

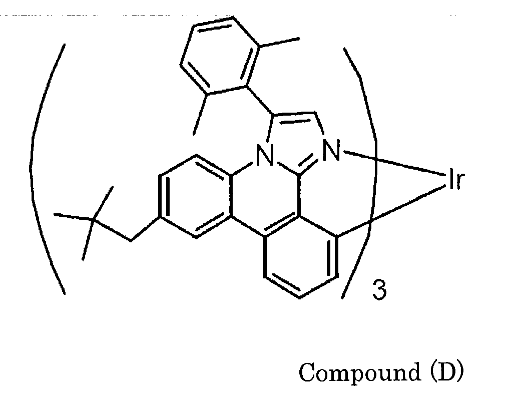

### (Production of Organic Electroluminescent Elements of Production Example 5)

Organic electroluminescent elements of Examples 16 to 18 and Comparative Examples 20 to 23 were produced in the same manner as in Production Example 1, except that mCP (bis-carbazole benzene) was used as the host material, and the organic device deposition materials containing the compound (D), serving as the luminescent material, varied in average particle diameter and uniformity degree for Examples 16 to 18 and Comparative Examples 20 to 23 were used as the deposition material.

The resulting organic electroluminescent elements were evaluated for initial decrease and film forming uniformity in the same manner as in Production Example 1. The results are shown in Table 5.

**Table 5**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 16 | 11 | 2.7 | 11.5 to 12.3 | 0.8 | A | A | A |
| Ex. 17 | 98 | 2.8 | 11.7 to 12.3 | 0.6 | A | A | A |
| Ex. 18 | 192 | 2.8 | 11.8 to 12.2 | 0.4 | A | A | A |
| Comp. Ex. 20 | 4 | 2.2 | 10.7 to 13.2 | 2.5 | B | B | B |
| Comp. Ex. 21 | 248 | 2.3 | 10.5 to 13.5 | 3.0 | B | B | B |
| Comp Ex. 22 | 598 | 2.6 | 9.8 to 14.0 | 4.2 | C | B | B |
| Comp Ex. 23 | 118 | 4.6 | 9.4 to 1.2 | 4.8 | C | B | B |

| | | | | | | | |
|---|---|---|---|---|---|---|---|
| In Table 5, angstrom/s means 0.1 nm/s. | | | | | | | |

### [Production Example 6: Examples 19 to 21 and Comparative Examples 24 to 27]

Organic device deposition materials for Examples 19 to 21 and Comparative Examples 24 to 27 shown in Table 6 were produced in the same manner as in Production Example 1, except that the compound (A) serving as the host material was changed to a luminescent material of compound (E) having the following structural formula (Production Example 6).

Measurement of the average particle diameter and the uniformity degree, as well as the deposition rate, and evaluation of the deposition rate stability were conducted in the same manner as performed for the organic device deposition materials of Production Example 1. The results are shown in Table 6.

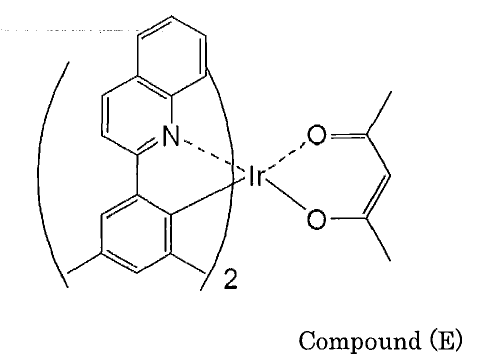

### (Production of Organic Electroluminescent Elements of Production Example 6)

Organic electroluminescent elements of Examples 19 to 21 and Comparative Examples 24 to 27 were produced in the same manner as in Production Example 1, except that mCP (bis-carbazole benzene) was used as the host material, and the organic device deposition materials containing the compound (E), serving as the luminescent material, varied in average particle diameter and uniformity degree for Examples 19 to 21 and Comparative Examples 24 to 27 were used as the deposition material.

The resulting organic electroluminescent elements were evaluated for initial decrease and film forming uniformity in the same manner as in Production Example 1. The results are shown in Table 6.

**Table 6**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 19 | 13 | 2.4 | 11.4 to 12.6 | 1.2 | A | A | A |
| Ex. 20 | 89 | 3.0 | 11.6 to 12.4 | 0.8 | A | A | A |
| Ex. 21 | 190 | 2.8 | 11.7 to 12.3 | 0.6 | A | A | A |
| Comp. Ex. 24 | 4 | 2.8 | 10.4 to 13.5 | 3.1 | C | B | B |
| Comp. Ex. 25 | 236 | 2.5 | 10.6 to 13.4 | 2.8 | B | B | B |
| Comp Ex. 26 | 586 | 2.7 | 9.7 to 14.1 | 4.4 | C | B | B |
| Comp Ex. 27 | 123 | 4.8 | 9.2 to 14.6 | 5.4 | C | B | B |

| | | | | | | | |
|---|---|---|---|---|---|---|---|
| In Table 6, angstrom/s means 0.1 nm/s. | | | | | | | |

### [Production Example 7: Examples 22 to 24 and Comparative Examples 28 to 31]

Organic device deposition materials for Examples 22 to 24 and Comparative Examples 28 to 31 shown in Table 7 were produced in the same manner as in Production Example 1, except that the compound (A) serving as the host material was changed to a luminescent material of compound (F) having the following structural formula (Production Example 7).

Measurement of the average particle diameter and the uniformity degree, as well as the deposition rate, and evaluation of the deposition rate stability were conducted in the same manner as performed for the organic device deposition materials of Production Example 1. The results are shown in Table 7.

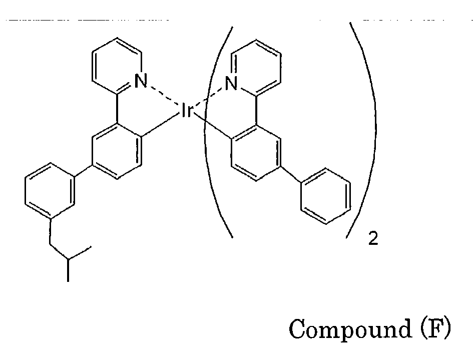

### (Production of Organic Electroluminescent Elements of Production Example 7)

Organic electroluminescent elements of Examples 22 to 24 and Comparative Examples 28 to 31 were produced in the same manner as in Production Example 1, except that mCP (bis-carbazole benzene) was used as the host material, and the organic device deposition materials containing the compound (F), serving as the luminescent material, varied in average particle diameter and uniformity degree for Examples 22 to 24 and Comparative Examples 28 to 31 were used as the deposition material.

The resulting organic electroluminescent elements were evaluated for initial decrease and film forming uniformity in the same manner as in Production Example 1. The results are shown in Table 7.

**Table 7**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 22 | 12 | 2.6 | 11.5 to 12.3 | 0.8 | A | A | A |
| Ex. 23 | 99 | 2.8 | 11.8 to 12.2 | 0.4 | A | A | A |
| Ex. 24 | 188 | 2.9 | 11.2 to 12.8 | 1.6 | A | A | A |
| Comp. Ex. 28 | 5 | 2.7 | 10.5 to 13.4 | 2.9 | B | B | B |
| Comp. Ex. 29 | 277 | 2.6 | 10.6 to 13.4 | 2.8 | B | B | B |
| Comp Ex. 30 | 598 | 2.6 | 9.3 to 14.7 | 5.4 | C | B | B |
| Comp Ex. 31 | 102 | 5.1 | 9.2 to 14.9 | 5.7 | C | B | B |

| | | | | | | | |
|---|---|---|---|---|---|---|---|
| In Table 7, angstrom/s means 0.1 nm/s. | | | | | | | |

### [Production Example 8: Comparative Examples 32 and 33]

Organic device deposition materials for Comparative Examples 32 and 33 shown in Table 8 were produced in the same manner as in Production Example 1, except that the compound (A) serving as the host material was changed to a luminescent material of the compound (D) having the above structural formula and that no sublimation purification was performed (Production Example 8).

Measurement of the average particle diameter and the uniformity degree, as well as the deposition rate, and evaluation of the deposition rate stability were conducted in the same manner as performed for the organic device deposition materials of Production Example 1. The results are shown in Table 8.

### (Production of Organic Electroluminescent Elements of Production Example 8)

Organic electroluminescent elements of Comparative Examples 32 and 33 were produced in the same manner as in Production Example 1, except that mCP (bis-carbazole benzene) was used as the host material, and the organic device deposition materials containing the compound (D) that had not been subjected to sublimation purification, serving as the luminescent material, varied in average particle diameter and uniformity degree for Comparative Examples 32 and 33 were used as the deposition material.

The resulting organic electroluminescent elements were evaluated for initial decrease and film forming uniformity in the same manner as in Production Example 1. The results are shown in Table 8.

**Table 8**

| | Average particle diameter (µm) | Uniformity degree | Sublimation purifica tion | Deposition Rate set at 12.0 angstrom/s | Difference in deposition rate (angstrom/s) | Stability in deposition rate | Initial decrease | Film forming uniformity |
|---|---|---|---|---|---|---|---|---|
| Ex. 16 | 11 | 2.7 | once | 11.5 to 12.3 | 0.8 | A | A | A |
| Ex. 17 | 98 | 2.8 | once | 11.7 to 12.3 | 0.6 | A | A | A |
| Ex. 18 | 192 | 2.8 | once | 11.8 to 12.2 | 0.4 | A | A | A |
| Comp. Ex. 32 | 66 | 2.6 | none | 10.8 to 13.3 | 2.5 | B | B | B |
| Comp. Ex. 33 | 178 | 2.9 | none | 10.7 to 13.3 | 2.6 | B | B | B |

| | | | | | | | | |
|---|---|---|---|---|---|---|---|---|
| In Table 8, angstrom/s means 0.1 nm/s. | | | | | | | | |

As is clear from Table 8, the organic device deposition materials having a particle diameter and uniformity degree falling within the intended ranges but having undergone no sublimation purification were found to be poor in stability in deposition rate. Removing impurities in the material by sublimation purification could suppress the initial decrease and also achieve stable deposition rate and film forming uniformity.

### [Production Example 9: Comparative Examples 34 and 35]

Organic device deposition materials for Comparative Examples 34 and 35 shown in Table 9 were produced in the same manner as in Production Example 1, except that the compound (A) serving as the host material was changed to a luminescent material of the compound (E) having the above structural formula and that no sublimation purification was performed (Production Example 9).

Measurement of the average particle diameter and the uniformity degree, as well as the deposition rate, and evaluation of the deposition rate stability were conducted in the same manner as performed for the organic device deposition materials of Production Example 1. The results are shown in Table 9.

### (Production of Organic Electroluminescent Elements of Production Example 9)

Organic electroluminescent elements of Comparative Examples 34 and 35 were produced in the same manner as in Production Example 1, except that mCP (bis-carbazole benzene) was used as the host material, and the organic device deposition materials containing the compound (D) that had not been subjected to sublimation purification, serving as the luminescent material, varied in average particle diameter and uniformity degree for Comparative Examples 34 and 35 were used as the deposition material.

The resulting organic electroluminescent elements were evaluated for initial decrease and film forming uniformity in the same manner as in Production Example 1. The results are shown in Table 9.

**Table 9**

| | Average particle diameter (µm) | Uniformity degree | Sublimation purifica tion | Deposition Rate set at 12.0 angstrom/s | Difference in deposition rate (angstrom/s) | Stability in deposi tion rate | Initial decrease | Film forming uniformity |
|---|---|---|---|---|---|---|---|---|
| Ex. 19 | 13 | 2.4 | once | 11.4 to 12.6 | 1.2 | A | A | A |
| Ex. 20 | 89 | 3.0 | once | 11.6 to 12.4 | 0.8 | A | A | A |
| Ex. 21 | 190 | 2.8 | once | 11.7 to 12.3 | 0.6 | A | A | A |
| Comp. Ex. 34 | 75 | 2.9 | none | 10.9 to 13.2 | 2.3 | B | B | B |
| Comp. Ex. 35 | 191 | 2.7 | none | 10.8 to 13.2 | 2.4 | B | B | B |

| | | | | | | | | |
|---|---|---|---|---|---|---|---|---|
| In Table 9, angstrom/s means 0.1 nm/s. | | | | | | | | |

As is clear from Table 9, the organic device deposition materials having a particle diameter and uniformity degree falling within the intended ranges but having undergone no sublimation purification were found to be poor in stability in deposition rate. Removing impurities in the material by sublimation purification could suppress the initial decrease and also achieve stable deposition rate and film forming uniformity.

### (Production of Organic Electroluminescent Elements of Production Example 10)

Organic electroluminescent elements of Example 25 and Comparative Example 36 were produced in the same manner as in Production Example 1, except that the organic device deposition material used as the deposition material was a mixture of the compound (A) serving as the host material and the compound (E) serving as the luminescent material varied in average particle diameter and uniformity degree at a ratio by mass of 95 : 5.

The resulting organic electroluminescent elements were evaluated for initial decrease and film forming uniformity in the same manner as in Production Example 1. The results are shown in Table 10.

**Table 10**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 25 | 108 | 3.0 | 11.4 to 12.5 | 1.1 | A | A | A |
| Comp Ex. 36 | 285 | 3.2 | 10.1 to 13.8 | 3.7 | C | B | B |

| | | | | | | | |
|---|---|---|---|---|---|---|---|
| In Table 10, angstrom/s means 0.1 nm/s. | | | | | | | |

As is clear from Table 10, the material having the above-defined particle diameter and uniformity degree may be made of single material or a plurality of materials.

### (Production of Organic Electroluminescent Elements of Production Example 11)

Organic electroluminescent elements of Example 26 and Comparative Example 37 were produced in the same manner as in Production Example 1, except that the organic device deposition material used as the deposition material was a mixture of the compound (A) serving as the host material and the compound (F) serving as the luminescent material varied in average particle diameter and uniformity degree at a ratio by mass of 90 : 10.

The resulting organic electroluminescent elements were evaluated for initial decrease and film forming uniformity in the same manner as in Production Example 1. The results are shown in Table 11.

**Table 11**

| | Average particle diameter (µm) | Uniformity degree | Deposition Rate set at 12.0 angstrom/s | Difference in deposition rate (angstrom /s) | Stability in deposition rate | Initial decrease | Film forming uniformity |
|---|---|---|---|---|---|---|---|
| Ex. 26 | 97 | 2.9 | 11.2 to 12.6 | 1.4 | A | A | A |
| Comp Ex. 37 | 310 | 3.5 | 9.8 to 14.0 | 4.2 | C | B | B |

| | | | | | | | |
|---|---|---|---|---|---|---|---|
| In Table 11, angstrom/s means 0.1 nm/s. | | | | | | | |

As is clear from Table 11, the material having the above-defined particle diameter and uniformity degree may be made of single material or a plurality of materials.

### Industrial Applicability

The present invention can provide the organic device deposition material and method for producing organic devices using the organic device deposition material able to uniformly form a large-area film containing an organic compound with excellent stability of the deposition rate, while reducing variation in performance of the organic devices, and therefore be suitably for the production of an organic electroluminescent device, an organic thin film solar cell, and an organic field-effect transistor.

### Reference Signs List

- 1: Substrate
- 2: Anode
- 3: Hole injection layer
- 4: Hole transport layer
- 5: Luminescent layer
- 6: Electron transport layer
- 7: Electron injection layer
- 8: Cathode
- 10: Organic electroluminescent element

## Claims

1. A deposition material which is used for producing an organic device,
wherein the deposition material has an average particle diameter of 10 µm to 200 µm where the average particle diameter is expressed by D50%, and has a uniformity degree of 1.0 to 4.0 where the uniformity degree is expressed by D60% diameter/D10% diameter.

2. The deposition material according to claim 1, wherein the deposition material comprises an organic compound or an inorganic oxide.

3. The deposition material according to claim 1 or 2, wherein the deposition material is used for forming at least one organic layer disposed between a pair of electrodes of an organic electroluminescent element.

4. The deposition material according to claim 3, wherein the organic layer is a luminescent layer.

5. The deposition material according to claim 4, further comprising an Ir complex or a Pt complex.

6. A method for producing an organic device, comprising:
depositing the deposition material according to any one of claims 1 to 5 by a flash deposition method to form an organic layer.

7. An organic device obtained by the method for producing an organic device according to claim 6.
